Europäisches Patentamt

European Patent Office

Office européen des brevets

(11) Veröffentlichungsnummer: **0 080 157 B1**

# (12) EUROPÄISCHE PATENTSCHRIFT

(45) Veröffentlichungstag der Patentschrift: **17.04.91**

(51) Int. Cl.⁵: **H03D 3/00**

(21) Anmeldenummer: **82110600.2**

(22) Anmeldetag: **16.11.82**

(54) Verfahren und Anordnung zum Demodulieren zeitdiskreter frequenzmodulierter Signale.

(30) Priorität: **19.11.81 DE 3145919**

(43) Veröffentlichungstag der Anmeldung:
**01.06.83 Patentblatt 83/22**

(45) Bekanntmachung des Hinweises auf die
Patenterteilung:
**17.04.91 Patentblatt 91/16**

(84) Benannte Vertragsstaaten:
**AT DE FR GB IT**

(56) Entgegenhaltungen:
**EP-A- 0 029 376**
**EP-A- 0 046 213**

**ELECTRONIS LETTERS, Band 15, Nr. 16, August 1979, Seiten 489-490, London, GB; F.G.A. COUPE: "Digital frequency discriminator"**

(73) Patentinhaber: **Siemens Aktiengesellschaft**
**Wittelsbacherplatz 2**
**W-8000 München 2(DE)**

(72) Erfinder: **Haussmann, Wolfgang, Dipl.-Ing.**
**Untersbergstrasse 90**
**W-8000 München 90(DE)**

EP 0 080 157 B1

**Beschreibung**

Die Erfindung betrifft ein Verfahren zum Demodulieren zeitdiskreter frequenzmodulierter Signale nach dem Oberbegriff des jeweiligen Anspruchs 1. Es liegt für die Staaten AT und IT einerseits und DE, FR und GB andererseits jeweils ein eigener Auspruchsatz vor.

Die digitale Signalverarbeitung ermöglicht es, zahlreiche bisher in analoger Technik gelöste Aufgaben der Signalverarbeitung auch digital anzugehen. Hiervon gibt es aber verschiedene Ausnahmen. So wurde bisher zu den in analoger Technik verwendeten Demodulatoren für frequenzmodulierte Signale (FM-Signale) kein entsprechender digitaler Baustein beschrieben, der die Funktion einer FM-Demodulation mit vertretbarem Aufwand und in Echtzeit durchführen kann. Verschiedene Möglichkeiten, die digitalen Verfahren ähneln, haben sich in der Praxis als ungeeignet erwiesen. So sind Nulldurchgangs-Detektoren wenig geeignet, da durch den zwingend durchgeführten Abtastprozeß gerade die Nulldurchgänge verlorengehen. Angestrebt wird also eine Verarbeitung der Abtastwerte mit den Funktionen eines FM-Demodulators, wobei Auswirkungen der Amplitudenmodulation unterdrückt bzw. begrenzt werden.

Im einzelnen gibt es zur Demodulation zeitdiskreter frequenzmodulierter Signale bisher verschiedene Möglichkeiten:

Die Verwendung einer digitalen Phasenregelschleife (vergleiche Kelly, Gupta: "The Digital PLL as a Near-Optimum FM-Demodulator", IEEE Transaction on Communication, June 72) und die Methode eines nachgeführten adaptiven Filters (vergleiche Griffiths: "Rapid Measurement of Digital Instantaneous Frequency", IEEE Transactions of Acoustics, Speech and Signal Processing, April 75, Seiten 207 bis 221) führt zu Regelkreisen mit den hiermit verbundenen Problemen hinsichtlich beispielsweise Einschwingverhalten, Stabilität und so weiter. Die auch bereits erwogene schnelle Fourier-Transformation (vergleiche Roth: "Effective Measurements Using Digital Signal Analysis", IEEE Spektrum, April 71, Seiten 62 bis 70) erfordert einen vergleichsweise hohen Rechenaufwand zur Demodulation, so daß eine Echtzeitverarbeitung überwiegend auf dem Bereich niederer Trägerfrequenzen beschränkt bleibt.

Alle bereits diskutierten Verfahren benötigen also einen hohen Aufwand hinsichtlich der Systementwicklung und der Herstellung des entsprechenden Bausteins.

Ein Verfahren zum Demodulieren zeitdiskreter frequenzmodulierter Signale nach dem Oberbegriff des Anspruchs 1 ist bereits aus der EP-A-0 029 376 bekannt geworden. Neben dem konkreten Beispiel mit vier Abtastproben, die jeweils um $\pi/2$ zeitlich zueinander versetzt sind und der dazugehörenden Rechenvorschrift in der dortigen Formel 5 wird auch auf die Möglichkeit verwiesen, mehrere Abtastproben zu verwenden. Diese Verallgemeinerung des dort beschriebenen Verfahrens bezieht sich jedoch auf die Erhöhung der Abtastrate in einer vollen Periode. Die Anzahl der zur Frequenzdemodulation notwendigen Abtastproben bleibt aber konstant.

Der Erfindung liegt ebenfalls die Aufgabe zugrunde, eine Vielzahl von Möglichkeiten anzugeben, wie FM-Demodulation in einfacher Weise für zeitlich äquidistant abgetastete FM-Signale möglich ist.

Diese Aufgabe wird durch die kennzeichnenden Merkmale des jeweiligen Anspruchs 1 gelöst.

Das erfindungsgemäße Verfahren beruht also darauf, daß zunächst zwei Summen von Abtastproben gebildet werden und anschließend diese Summen der Division zugeführt werden. Dabei können beliebig viele Abtastproben verwendet werden, soweit die im Kennzeichen des jeweiligen Anspruchs 1 angegebene Vorschrift eingehalten wird.

Weiterbildungen der Erfindung sind Gegenstand der Ansprüche 2 und 3.

In der am 24.2.1982 für die staaten DE, FR und GB veröffentlichten EP-A-0 046 213 wird auch ein Verfahren zum Demodulieren zeitdiskreter frequenzmodulierter Signale beschrieben. Dabei wird das zu demodulierende Signal durch Verzögerungsglieder geleitet und genau drei Abtastproben des zu demodulierenden Signals derart miteinander verknüpft, daß das Ausgangssignal direkt der Momentanfrequenz proportional ist, die die drei Abtastproben enthält, vorgeschlagen. Dies kann dadurch erreicht werden, daß die Abtastproben in Zeitpunkten T und $T + 2T_A (T_A = \text{Taktperiode})$ addiert werden und daß die Summe durch einen der Abtastprobe im Zeitpunkt $T + T_A$ proportionalen Wert dividiert wird. Von einer Vielzahl von weiteren Möglichkeiten ist in dieser Druckschrift allerdings nicht die Rede. Dieser Stand der Technik nach Art. 54(3,4) EPÜ ist in dem separaten Auspruchsatz für die genannten Staaten berücksichtigt.

Um Störeinflüsse zu verringern, um die Eigenschaften des FM-Demodulators an den Anwendungsfall anpassen zu können und um in der Gestaltung einer Anordnung zum Demodulieren zeitdiskreter frequenzmodulierter Signale flexibler zu sein, ist es jedoch nötig, eine Vielzahl weiterer Möglichkeiten anzugeben, um die Demodulation von zeitlich äquidistanten, abgetasteten FM-Signalen durchzuführen.

Die Erfindung wird im folgenden an Hand der Figuren näher erläutert. Es zeigen:

Fig. 1     ein zu demodulierendes sinusförmiges Eingangssignal,

Fig. 2     das Signal der Fig. 1 in komplexer Darstellung (Zeigerdiagramm),

2

Fig. 3     eine weitere komplexe Darstellung eines Beispiels für die erfindungsgemäße Wahl der Abtastproben,

Fig. 4     ein Ausführungsbeispiel einer erfindungsgemäßen Anordnung und

Fig. 5     eine Demodulationskennlinie des nach der Anordnung der Fig. 4 arbeitenden Demodulators.

In den Figuren sind gleiche Elemente mit gleichen Bezugzeichen bezeichnet.

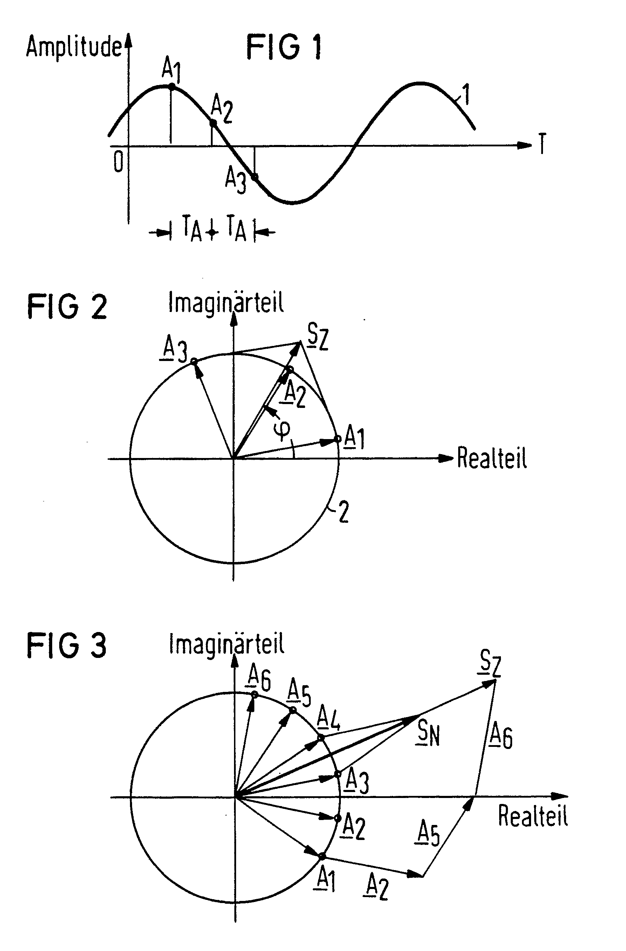

Die Fig. 1 zeigt ein sinusförmiges, zu demodulierendes Signal 1. Das analoge, frequenzmodulierte Signal 1 wird in konstanten Zeitabständen (Taktperiode $T_A$) abgetastet und in zeitdiskrete Abtastproben umgewandelt. In der Fig. 1 sind drei, durch Kreise hervorgehobene Abtastproben $A_1$, $A_2$ und $A_3$ eingezeichnet, wobei hier und im Folgenden unter einer Abtastprobe $A_i$ eine zum Zeitpunkt $(i-1)$ $T_A$ später als die Abtastprobe $A_1$ abgetastete Abtastprobe verstanden wird.

Das in der EP-A-0 046 213 angegebene Demodulationsverfahren beruht darauf, daß die den drei Abtastproben $A_1$, $A_2$, $A_3$ zugrundeliegende Frequenz$^f$(Momentanfrequenz) über die Vorschrift

$$f = C_1 \cdot \frac{A_1 + A_3}{2A_2} \qquad (1)$$

näherungsweise für $f = 1/4, 3/4, 5/4,.....$ der Abtastfrequenz $T_A$ oder exakt als analytisch ableitbare Formel mit

$$f = C_2 \cdot \arccos \frac{A_1 + A_3}{2A_2} \qquad (2)$$

wobei $C_1$ und $C_2$ Konstanten sind, bestimmbar ist.

Die EP-A-0 046 213 sieht zur Durchführung dieses Verfahrens eine Schaltungsanordnung vor, bei der dem Eingang für das zu demodulierende zeitdiskrete Signal einerseits ein Verzögerungsglied und andererseits ein Addierer nachgeschaltet sind, bei dem zwischen dem Verzögerungsglied und dem Addierer ein weiteres Verzögerungsglied liegt, bei dem weiterhin der Verbindungspunkt zwischen den beiden Verzögerungsgliedern und der Ausgang des Addierers mit einem Festwertspeicher verbunden ist und bei dem ferner am Ausgang des Festwertspeichers, in dem die Division und das Bilden der Arcuscosinus-Funktion vorgenommen wird, das demodulierte Signal liegt. Da jedes Verzögerungsglied um eine Taktperiode $T_A$ verzögert, liegt am Ausgang des Addierers die Summe aus dem unverzögerten und den um zwei Taktperioden $T_A$ verzögerten Eingangssignal an. Der Festwertspeicher bzw. ein an Stelle des Festwertspeichers vorgesehener Dividierer kann also die Summe der Abtastproben $A_1$ und $A_3$ durch die Abtastprobe $A_2$ dividieren.

Die Demodulationskennlinie, die den Verlauf der Ausgangsspannung des Festwertspeichers bzw. des Dividierers in Abhängigkeit von der Momentanfrequenz f des zu demodulierenden FM-Signals darstellt, ist bei Bildung der Arcuscosinus-Funktion aus Geradenstücken in Form einer Dreiecksfunktion zusammengesetzt. Wird auf die Bildung der Arcuscosinus-Funktion verzichtet, so stellt die Demodulationskennlinie eine Cosinus-Funktion dar, die für FM-Signale im Bereich um das 0,25-fache und das 0,75-fache der Abtastfrequenz hinreichend linear ist.

Ausgehend von den analytisch ableitbaren Formeln (1) und (2) haben weitergehende Untersuchungen ergeben, daß erfindungsgemäß eine Vielzahl weiterer Möglichkeiten existieren, um die Aufgabe der Demodulation von zeitlich äquidistant abgetasteten, annähernd sinusförmigen FM-Signalen durchzuführen. Zu diesem Zwecke wird das Signal 1 der Fig. 1 entsprechend der Fig. 2 in komplexer Darstellung gezeichnet. Eine entsprechende komplexe Darstellung von Wechselstromgrößen im sogenannten Zeigerdiagramm ist in der komplexen Wechselstromrechnung üblich und z.B. im Fachlexikon ABC Physik, Band 1, Verlag Harri Deutsch, Zürich und Frankfurt a.M., 1974, Seiten 280 und 281 bekannt. Das cosinusförmige Signal 1 wird zu einem Kreis 2, auf dessen Bogen die Abtastproben liegen. Der Realteil eines Punktes auf dem Kreisbogen 2 entspricht einen Punkt auf der Cosinus-Funktion 1 von Fig. 1.

In der komplexen Darstellung lassen sich vom Ursprung 0 zu den Proben Zeiger (Vektoren) $\underline{A}_1$, $\underline{A}_2$ und $\underline{A}_3$ einzeichnen. Weiterhin kann die Vektorsumme $\underline{S}_z$ der Zeiger $\underline{A}_1$ und $\underline{A}_3$ eingezeichnet werden, die in Gleichung (1) den Zähler des Bruchs bilden. Man erkennt, daß in der Fig. 2 die Vektorsumme $\underline{S}_z$

3

dieselbe Phasenlage $\phi$ aufweist wie der Zeiger des Nenners $2\mathrm{x}A_2$ von Gleichung (1), wobei unter Phasenlage der Winkel $\phi$ verstanden wird, der von der reellen Achse und den Vektoren $\underline{A}_2$ bzw. $\underline{S}_z$ gebildet wird.

Weitere Untersuchungen ergaben, daß weitere funktionsfähige Demodulationsverfahren vor allem auch unter Verwendung von mehr als drei Abtastproben existieren. Damit gelingt es, beim Demodulieren Störeinflüsse zu verringern, Demodulatoren mit speziellen Eigenschaften (Kennlinien) zu entwerfen und die Anordnung zum Demodulieren flexibler zu gestalten, z.B. weniger Bits zur Verarbeitung zu benötigen. Alle erfindungsgemäßen funktionsfähigen Demodulationsverfahren haben die Form, daß eine erste gewichtete Summe von Abtastproben (Dividend) durch eine zweite gewichtete Summe von Abtastproben (Divisor) dividiert wird. Es ist lediglich die Bedingung zu erfüllen, daß die Vektorsumme der Abtastproben des Zählers (Dividend) dieselbe oder eine um $n \cdot \pi$ (n ganzzahlig) verschiedene Phasenlage in Bezug auf die Vektorsumme der Abtastproben des Nenners (Divisor) besitzt.

Will man eine bestimmte Auswahl von Abtastproben für Zähler und Nenner im Zeigerdiagramm zeichnen, so ist unerheblich, bei welcher Phasenlage $\phi$ für den ersten Zeiger $A_1$ man das Zeigerdiagramm beginnt. Wesentlich ist lediglich, daß die Phasenlagen zeitlich aufeinanderfolgender äquidistanter Abtastproben sich um konstante, durch Abtastung mit konstanter Taktperiode verursachte Phasendifferenzen unterscheiden.

Die Fig. 3 zeigt die komplexe Darstellung eines funktionsfähigen Beispiels mit vier Abtastproben ($A_1$, $A_2$, $A_5$, $A_6$) im Zähler und zwei Abtastproben ($A_3$, $A_4$) im Nenner, wobei die Abtastprobe $A_2$ um eine Taktperiode $T_A$ später als die Abtastprobe $A_1$ gewonnen wurde etc.. Der Dividend besteht in diesem Beispiel aus der Summe der Abtastproben $A_1$, $A_2$, $A_5$ und $A_6$. Der Divisor besteht aus der Summe der Abtastproben $A_3$ und $A_4$. Wie in der Fig. 3 gezeigt, ergibt die Vektorsumme des Dividenden $S_z$, die einer Vektoraddition der den Abtastproben $A_1$, $A_2$, $A_5$ $A_6$ entsprechenden Vektoren $A_1$, $A_2$, $A_5$, $\overline{A}_6$ entspricht, dieselbe Phasenlage wie die Vektorsumme $S_N$ des Divisors, die durch Addition der Zeiger $A_3$ und $A_4$ gebildet wird. Solange die Phasenlage der Vektorsummen von Dividend und Divisor der genannten Relation entsprechen, ist die Art der Gewichtung der einzelnen Summanden von Zähler und Nenner bezüglich Gewichtungsfaktor und Vorzeichen beliebig. Durch die Wahl der Gewichtungsfaktoren kann die Amplitude der Demodulationskennlinie geändert werden oder die gesamte Demodulationskennlinie parallel verschoben werden, ihre prinzipielle Form bleibt unverändert.

Beispiele für funktionsfähige Demodulationsverfahren, bei denen eine erste gewichtete Summe von Abtastproben Z durch eine zweite gewichtete Summe von Abtastproben N dividiert wird, wobei die Abtastproben so gewählt sind, daß Vektorsumme von Dividend Z und Divisor N identische oder nur um $n \cdot \pi$ verschiedene Phasenlagen aufweisen, sind z.B.:

$Z = A_1 + A_2 + A_3$, $N = A_2$;

$Z = 2 \cdot A_1 + 2 \cdot A_3$, $N = A_2$;

$Z = A_1 + A_4$, $N = A_2 + A_3$;

$Z = 2 \cdot A_1 + A_2 + A_3 + 2 \cdot A_4$, $N = A_2 + A_3$;

$Z = A_1 + 2 \cdot A_2 + A_3 + 2 \cdot A_4 + A_5$, $N = A_2 + 2$, $A_3 + A_4 \cdot$

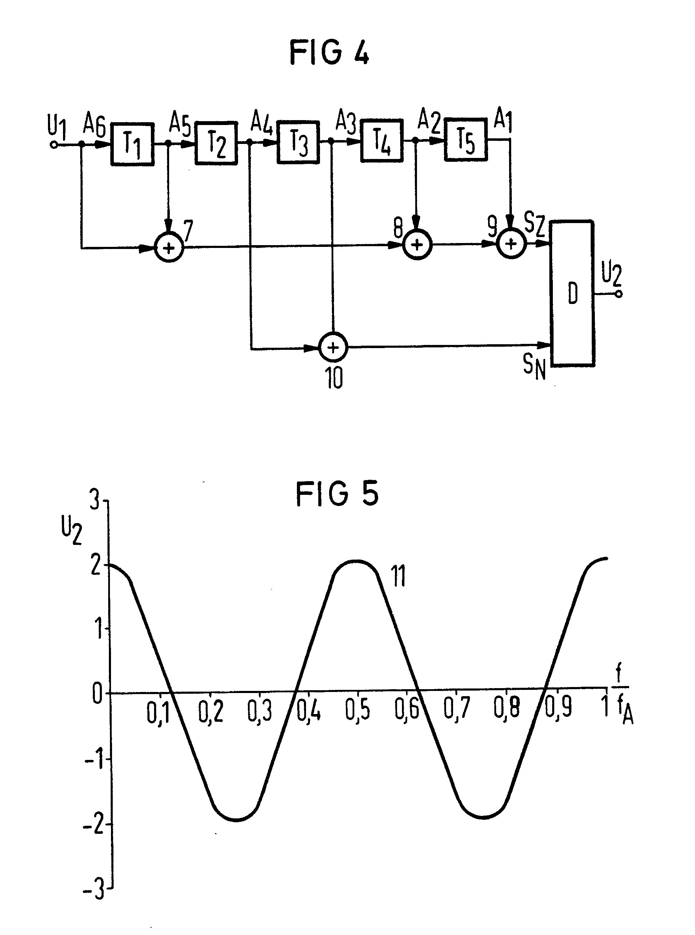

Die Fig. 4 zeigt ein Ausführungsbeispiel für eine Anordnung zur Durchführung des erfindungsgemäßen Verfahrens. Beim Ausführungsbeispiel nach Fig. 4 werden sechs Abtastproben $A_1$ bis $A_6$ in der der Fig. 3 entsprechenden Weise verknüpft, d.h. der Dividend wird durch die Summe der Abtastproben $A_1$, $A_2$, $A_5$ und $A_6$ gebildet, der Divisor durch die Summe der Abtastproben $A_3$ und $A_4$. Die Anordnung besteht aus einer Reihenschaltung von fünf Verzögerungsgliedern $T_1$, $T_2$, $T_3$, $T_4$ und $T_5$, wobei jedes Verzögerungsglied das an ihm anliegende Eingangssignal um eine Periode des Abtasttaktes $T_A$ verzögert. Am Eingang des ersten Verzögerungsgliedes $T_1$ liegt das zu demodulierende zeitdiskrete frequenzmodulierte Signal $U_1$ an. Zur Division von Dividenden durch Divisor ist ein Dividierer D vorgesehen, der den Dividenden $S_Z$ durch den Divisor $S_N$ dividiert und ausgangsseitig als Ergebnis das demodulierte Signal $U_2$ ausgibt.

Zur Summationsbildung sind vier Addierer 7, 8, 9 und 10 vorgesehen. Der erste Addierer 7 ist mit seinem ersten Eingang mit dem Eingang des Verzögerungsgliedes $T_1$ und mit seinem zweiten Eingang mit dem Ausgang des Verzögerungsgliedes $T_1$ verbunden. Der zweite Addierer 8 ist mit seinem ersten Eingang mit dem Ausgang des ersten Addierers 7 und mit seinem zweiten Eingang mit dem Ausgang des vierten Verzögerungsgliedes $T_4$ verbunden, während der dritte Addierer 9 mit seinem ersten Eingang mit dem Ausgang des zweiten Addierers 8 und mit seinem zweiten Eingang mit dem Ausgang des fünften Verzögerungsgliedes $T_5$ verbunden ist. Der am Ausgang des dritten Addierers 9 anstehende Dividend $S_Z$ beaufschlagt den Dividierer D. Der erste Eingang des vierten Addierers 10 wird vom Ausgang des zweiten Verzögerungsgliedes $T_2$ beaufschlagt, während der zweite Eingang des vierten Addierers 10 vom Ausgang des dritten Verzögerungsgliedes $T_3$ beaufschlagt wird. Dem Ausgang des vierten Addierers 10 ist der Divisor $S_N'$ der den Dividierer D beaufschlagt, entnehmbar.

4

Die Anordnung arbeitet wie folgt:

Liegt am Ausgang des fünften Verzögerungsgliedes $T_5$ die Abtastprobe $A_1$, wie in der Fig. 4 dargestellt, so liegt am Ausgang des vierten Verzögerungsgliedes $T_4$ die Abtastprobe $A_2$, am Ausgang des dritten Verzögerungsgliedes $T_3$ die Abtastprobe $A_3$, am Ausgang des zweiten Verzögerungsgliedes $T_2$ die Abtastprobe $A_4$, am Ausgang des ersten Verzögerungsgliedes $T_1$ die Abtastprobe $A_5$ und am Eingang des ersten Verzögerungsgliedes $T_1$ die Abtast probe $A_6$. Die Addierer 7, 8 und 9 bilden somit die Summe $A_6 + A_5 + A_2 + A_1$ (Dividend), während der Addierer 10 die Summe $A_4 + A_3$ und damit den Divisor bildet.

Die Fig. 5 zeigt die analytisch oder meßtechnisch ermittelbare Demodulationskennlinie 11 des in der Fig. 4 gezeigten Ausführungsbeispiels für einen erfindungsgemäßen Demodulator, wobei die Achsen jeweils geeignet normiert sind. Auf der x-Achse ist dabei die Momentanfrequenz f des zu demodulierenden FM-Signals bezogen auf die Taktfrequenz $f_A$ ($f_A = 1/T_A$) aufgetragen. Auf der y-Achse ist das demodulierte Signal $U_2$ angegeben. Die Demodulationskennlinie 11 weist eine Cosinusform auf, die in einem größeren Bereich in Umgebung der Null-Durchgänge nur unwesentliche Nichtlinearitäten aufweist, so daß das Ausgangssignal $U_2$ des Dividierers D in diesen Bereichen direkt der Momentanfrequenz f des Eingangssignals $U_1$ proportional ist. Soll im nichtlinearen Bereich der Kennlinie gearbeitet werden, so kann die Kennlinie z.B. mittels eines entsprechend programmierten Festwertspeichers, linearisiert werden.

Werden von diesem Ausführungsbeispiel abweichende gewichtete Summen von Abtastproben für den Dividenden und den Divisor, z.B. die in den oben erwähnten Beispielen genannten, angewandt, so sind Anzahl der Verzögerungsglieder, Anordnung der Addierer bzw. Addierstufen und gegebenenfalls Anordnungen zur Bildung von Gewichtungsfaktoren entsprechend geändert vorzusehen. Bei niederen Taktfrequenzen $T_A$ kann der Dividierer D durch ein handelsübliches Rechenwerk realisiert werden. Bei höheren Taktfrequenzen empfiehlt es sich, den Dividierer D durch einen Festwertspeicher, in dem die Divisionser gebnisse je nach Größe von Dividend und Divisor bereits abgespeichert sind, zu ersetzen.

Besonderer Vorteil des erfindungsgemäßen Verfahrens ist die flexible Wahl der vervendbaren Abtastproben und die Tatsache, daß die unbekannte Phasenbeziehung zwischen Abtasttakt und zu demodulierendem FM-Signal nicht berücksichtigt werden muß.

Das erfindungsgemäße Verfahren ist insbesondere zur Demodulation frequenzmodulierter Stereorundfunksignale und bei digital arbeitenden Farbfernsehempfängern zur Demodulation des bei SECAM-Norm in frequenzmodulierter Form vorliegenden Farbartsignales anwendbar. Auch ist eine Anwendung bei allen Datenübertragungs- und Speicherungsverfahren, welche mit Frequenzumtastung (FSK) arbeiten, vorteilhaft.

**Ansprüche**

1. Verfahren zum Demodulieren zeitdiskreter frequenzmodulierter Signale, bei dem Abtastproben ($A_1$, $A_2$,...) des zu demodulierenden Signales (1) derart miteinander verknüpft werden, daß aus dem Ausgangssignal ($U_2$) auf die Momentanfrequenz (f) des zu demodulierenden Signales (1) geschlossen werden kann, bei dem zur Gewinnung des Ausgangssignales ($U_2$) eine Division aus einer ersten gewichteten Summe ($S_Z$) von k äquidistanten Abtastproben (Dividend) durch eine zweite gewichtete Summe ($S_N$) von m äquidistanten Abtastproben (Divisor) durchgeführt wird, ($k,m = 1, 2, 3,...$) **dadurch gekennzeichnet,** daß die Abtastproben ($A_1$, $A_2$,...) so gewählt werden, daß bei einer Darstellung der Abtastproben ($A_1$, $A_2$....) im Zeigerdiagramm, bei der jede Abtastprobe ($A_1$, $A_2$,...) als komplexe Zahl einem Vektor ($\underline{A}_1$, $A_2$,...) entspricht, die Phasenlage der Vektorsumme des Dividenden ($S_Z$) um $n \cdot \pi$ der Vektorsumme des Divisors ($\underline{S}_N$) entspricht ($n = 0, 1, 2,...$), wobei die Auswahl von drei um jeweils einen konstanten Zeitabstand $T_A$ zueinander verschobene Abtastproben ($A_1$, $A_2$, $A_3$) und deren Division gemäß

$$\frac{A_1 + A_3}{K \cdot A_2}$$

mit K als Proportionalitätsfaktor und die Auswahl von vier um jeweils $\pi/2$ zueinander verschobene Abtastproben ($A_1$, $A_2$, $A_3$, $A_4$) und deren Division gemäß

$$\frac{A_4 - A_1 - A_3 + A_2}{2 \cdot A_3 - 2 \cdot A_2}$$

ausgenommen ist.

2. Verfahren nach Anspruch 1,
**dadurch gekennzeichnet,**
daß die Summanden von Divisor ($S_N$) und Dividend ($S_Z$) zur Einstellung der Amplitude oder Phase der sich beim Demodulieren ergebenden Demodulatorkennlinie gewichtet werden.

3. Verfahren nach Anspruch 1 oder 2,
**dadurch gekennzeichnet,**
daß vom Ergebnis der Division die Arcus-cosinus-Funktion gebildet wird.

Patentansprüche für folgende Vertragsstaaten: AT, IT

1. Verfahren zum Demodulieren zeitdiskreter frequenzmodulierter Signale, bei dem Abtastproben ($A_1$, $A_2$,...) des zu demodulierenden Signales (1) derart miteinander verknüpft werden, daß aus dem Ausgangssignal ($U_2$) auf die Momentanfrequenz (f) des zu demodulierenden Signales (1) geschlossen werden kann, bei dem zur Gewinnung des Ausgangssignales ($U_2$) eine Division aus einer ersten gewichteten Summe ($S_Z$) von k äquidistanten Abtastproben (Dividend) durch eine zweite gewichtete Summe ($S_N$) von m äquidistanten Abtastproben (Divisor) durchgeführt wird (k,m = 1, 2, 3,...)
**dadurch gekennzeichnet,**
daß die Abtastproben ($A_1$, $A_2$,...) so gewählt werden, daß bei einer Darstellung der Abtastproben ($A_1$, $A_2$...) im Zeigerdiagramm, bei der jede Abtastprobe ($A_1$, $A_2$,...) als komplexe Zahl einem Vektor ($A_1$, $A_2$,...) entspricht, die Phasenlage der Vektorsumme des Dividenden ($S_Z$) um n·$\pi$ der Vektorsumme des Divisors ($S_N$) entspricht (n = 0, 1, 2, ...), wobei die Auswahl von vier um jeweils $\pi/2$ zueinander verschobene Abtastproben ($A_1$, $A_2$, $A_3$, $A_4$) und deren Division gemäß

$$\frac{A_4 - A_1 - A_3 + A_2}{2 \cdot A_3 - 2 \cdot A_2}$$

ausgenommen ist.

2. Verfahren nach Anspruch 1,
**dadurch gekennzeichnet,**
daß die Summanden von Divisor ($S_N$) und Dividend ($S_Z$) zur Einstellung der Amplitude oder Phase der sich beim Demodulieren ergebenden Demodulatorkennlinie gewichtet werden.

3. Verfahren nach Anspruch 1 oder 2,
**dadurch gekennzeichnet,**
daß vom Ergebnis der Division die Arcus-cosinus-Funktion gebildet wird.

## Claims

1. Method for demodulating time-discrete frequency-modulated signals in which sampled values ($A_1$, $A_2$,...) of the signal (1) to be demodulated are combined with one another in such a manner that from the output signal ($U_2$) the instantaneous frequency (f) of the signal (1) to be demodulated can be inferred, in which, for obtaining the output signal ($U_2$), a division of a first weighted sum ($S_Z$) of k equidistant sampled values (dividend) by a second weighted sum ($S_N$) of m equidistant sampled values

6

(divisor) is carried out (k, m = 1,2,3,...), characterised in that the sampled values A₁, A₂,...) are selected in such a manner that, when the sampled values (A₁, A₂,...) are represented in a vector diagram in which each sampled value (A₁, A₂,...), as a complex number, corresponds to a a vector (A ₁, A ₂,...), the phase relationship of the vector sum of the dividend (S$_Z$) corresponds by m.π to the vector sum of the devisor (S $_N$) (n = 0, 1, 2,...), wherein the selection of three sampled values (A₁, A₂, A₃), in each case displaced with respect to one another by a constant time interval T$_A$, and their division according to

$$\frac{A_1 \; + \; A_3}{K \; \cdot \; A_2}$$

with K as proportionality factor, and the selection of four sampled values (A₁, A₂, A₃, A₄), displaced with respect to one another by in each case π/2, and their division according to

$$\frac{A_4 \; - \; A_1 \; - \; A_3 \; + \; A_2}{2 \; \cdot \; A_3 \; - \; 2 \; \cdot \; A_2}$$

is excepted.

2. Method according to Claim 1, characterised in that the summands of devisor (S$_N$) and dividend (S$_Z$) are weighted for setting the amplitude or phase of the demodulator characteristic produced during the demodulating.

3. Method according to Claim 1 or 2, characterised in that the arc-cosine function is formed from the result of the division.

Claims for the following Contracting States: AT, IT

1. Method for demodulating time-discrete frequency-modulated signals in which sampled values (A₁, A₂,...) of the signal (1) to be demodulated are combined with one another in such a manner that from the output signal (U₂) the instantaneous frequency (f) of the signal (1) to be demodulated can be inferred, in which, for obtaining the output signal (U₂), a division of a first weighted sum (S$_Z$) of k equidistant sampled values (dividend) by a second weighted sum (S$_N$) of m equidistant sampled values (divisor) is carried out (k, m = 1,2,3,...), characterised in that the sampled values A₁, A₂,...) are selected in such a manner that, when the sampled values (A₁, A₂,...) are represented in a vector diagram in which each sampled value (A₁, A₂,...), as a complex number, corresponds to a a vector (A ₁, A ₂,...), the phase relationship of the vector sum of the dividend (S$_Z$) corresponds by m.π to the vector sum of the devisor (S $_N$) (n = 0, 1, 2,...), wherein the selection of four sampled values (A₁, A₂, A₃, A₄), displaced with respect to one another by in each case π/2, and their division according to

$$\frac{A_4 \; - \; A_1 \; - \; A_3 \; + \; A_2}{2 \; \cdot \; A_3 \; - \; 2 \; \cdot \; A_2}$$

is excepted.

2. Method according to Claim 1, characterised in that the summands of devisor (S$_N$) and dividend (S$_Z$) are weighted for setting the amplitude or phase of the demodulator characteristic produced during the demodulating.

3. Method according to Claim 1 or 2, characterised in that the arc-cosine function is formed from the result of the division.

7

**Revendications**

1. Procédé pour démoduler des signaux discrets dans le temps et modulés en fréquence, et selon lequel on combine entre eux des échantillons ($A_1, A_2,...$) du signal (1) devant être démodulé, de manière à pouvoir, à partir du signal de sortie ($U_2$), tirer des conclusions sur la fréquence instantanée (f) du signal (1) devant être démodulé, et selon lequel pour l'obtention du signal de sortie ($U_2$), on effectue la division d'une première somme pondérée ($S_Z$) de k échantillons équidistants (dividende) par une seconde somme pondérée ($S_N$) de m échantillons équidistants (diviseur) (k,m = 1,2,3,...) caractérisé par le fait

qu'on choisit les échantillons ($A_1, A_2,...$) de manière que, lors d'une représentation des échantillons ($A_1, A_2,...$) dans le diagramme vectoriel, pour laquelle chaque échantillon ($A_1, A_2,...$) correspond, en tant que nombre complexe, à un vecteur ($\underline{A}_1, \underline{A}_2,...$), la position de phase de la somme vectorielle du dividende ($\underline{S_Z}$) correspond à $n.\pi$ fois la somme vectorielle du diviseur ($\underline{S}_N$) (n = 0,1,2,...), le choix de trois échantillons ($A_1, A_2, A_3$), décalés respectivement les uns par rapport aux autres, d'un intervalle de temps constant $T_A$, et leur division étant obtenus conformément à

$$\frac{A_1 + A_3}{K \cdot A_2}$$

K étant le facteur de proportionnalité, et le choix de quatre échantillons ($A_1, A_2, A_3, A_4$), décalés réciproquement de $\pi/2$, et leur division étant obtenus conformément à

$$\frac{A_4 - A_1 - A_3 + A_2}{2 \cdot A_3 - 2 \cdot A_2}$$

2. Procédé suivant la revendication 1, caractérisé par le fait que les termes d'addition du diviseur ($S_N$) et du dividende ($S_Z$) sont pondérés pour le réglage de l'amplitude ou de la phase de la courbe caractéristique du démodulateur, obtenue lors de la démodulation.

3. Procédé suivant les revendications 1 ou 2, caractérisé par le fait que la fonction arc-cosinus est formée à partir du résultat de la division.

Revendications pour les Etats contractant suivants: AT, IT

1. Procédé pour démoduler des signaux discrets dans le temps et modulés en fréquence, et selon lequel on combine entre eux des échantillons ($A_1, A_2,...$) du signal (1) devant être démodulé, de manière à pouvoir, à partir du signal de sortie ($U_2$), tirer des conclusions sur la fréquence instantanée (f) du signal (1) devant être démodulé, et selon lequel pour l'obtention du signal de sortie ($U_2$), on effectue la division d'une première somme pondérée ($S_Z$) de k échantillons équidistants (dividende) par une seconde somme pondérée ($S_N$) de m échantillons équidistants (diviseur) (k,m = 1,2,3,...) caractérisé par le fait

qu'on choisit les échantillons ($A_1, A_2,...$) de manière que, lors d'une représentation des échantillons ($A_1, A_2,...$) dans le diagramme vectoriel, pour laquelle chaque échantillon ($A_1, A_2,...$) correspond, en tant que nombre complexe, à un vecteur ($\underline{A}_1, \underline{A}_2,...$), la position de phase de la somme vectorielle du dividende ($\underline{S_Z}$) correspond à $n.\pi$ fois la somme vectorielle du diviseur ($\underline{S}_N$) (n = 0,1,2,...), le choix de quatre échantillons ($A_1, A_2, A_3, A_4$), décalés réciproquement de $\pi/2$, et leur division étant obtenus conformément à

$$\frac{A_4 - A_1 - A_3 + A_2}{2 \cdot A_3 - 2 \cdot A_2}$$

2. Procédé suivant la revendication 1, caractérisé par le fait que les termes d'addition du diviseur ($S_N$) et du dividende ($S_Z$) sont pondérés pour le réglage de l'amplitude ou de la phase de la courbe caractéristique du démodulateur, obtenue lors de la démodulation.

3. Procédé suivant les revendications 1 ou 2, caractérisé par le fait que la fonction arc-cosinus est formée à partir du résultat de la division.

## FIG 1

Amplitude

$A_1$

$A_2$

$A_3$

0

T

$T_A$ ┼ $T_A$

1

## FIG 2

Imaginärteil

$\underline{A}_3$

$\underline{S}_Z$

$\underline{A}_2$

$\varphi$

$\underline{A}_1$

Realteil

2

## FIG 3

Imaginärteil

$\underline{A}_6$  $\underline{A}_5$

$\underline{A}_4$

$\underline{S}_Z$

$\underline{S}_N$

$\underline{A}_6$

$\underline{A}_3$

Realteil

$\underline{A}_2$

$\underline{A}_5$

$\underline{A}_1$

$\underline{A}_2$

## FIG 4

## FIG 5